Europäisches Patentamt

(19) European Patent Office

Office européen des brevets

(11) Publication number: **0 439 301 A1**

(12) **EUROPEAN PATENT APPLICATION**

(21) Application number: 91300424.8

(51) Int. Cl.⁵: **H01L 27/118**

(22) Date of filing: 18.01.91

(30) Priority: 22.01.90 JP 12353/90

(43) Date of publication of application:
31.07.91 Bulletin 91/31

(84) Designated Contracting States:
DE FR GB IT

(71) Applicant: HITACHI, LTD.
6, Kanda Surugadai 4-chome
Chiyoda-ku, Tokyo 101 (JP)

(72) Inventor: Kadono, Shinji
1-22-48, Musashinodai
Fussa-shi, Tokyo (JP)
Inventor: Shibata, Manabu
105 Sentoraruhaitsu, 383-6, Kaminakai-machi
Takasaki-shi, Gunma (JP)
Inventor: Komatsu, Toru
202 Matsushimakoupo, 3-18-9, Shin-machi
Kokubunji-shi, Tokyo (JP)
Inventor: Sakamoto, Masataka
Hitachiseishinryo, 391-8, Nishiyokote-machi
Takasaki-shi, Gunma (JP)

(74) Representative: Calderbank, Thomas Roger et al
MEWBURN ELLIS 2 Cursitor Street
London EC4A 1BQ (GB)

(54) Semiconductor integrated-circuit device.

(57) In a semiconductor integrated-circuit device comprising Bi-CMOS cells with each being configurable as a Bi-CMOS circuit or a CMOS circuit and CMOS cells with each being configurable as a CMOS circuit, wherein a combining ratio of the Bi-CMOS cells to the CMOS cells is of m/n, where m and n are both integers and m is smaller than n, the Bi-CMOS and CMOS cells are laid out so that the ratio of the cell width lx1 of each Bi-CMOS cell to the cell width lx2 of each CMOS cell is l/l or l/k, where l and k are both integers with l being greater than k, and the ratio of the cell height ly1 of each Bi-CMOS cell to the cell height ly2 of each CMOS cells is l/l or g/h, where g and h are both integers with g being greater than h.

EP 0 439 301 A1

## SEMICONDUCTOR INTEGRATED-CIRCUIT DEVICE

The present invention relates to a semiconductor integrated-circuit device implemented by a master-slice technique. To be more specific, the invention relates to an effective technology applied to a gate array comprising a combination of complementary MOS (referred to hereafter as CMOS) circuits made of N-channel MOSFETs (Metal Oxide Semiconductor Field Effect Transistors) and P-channel MOSFETs, and Bi-CMOS circuits employing bipolar transistors at the outputs of the CMOS circuits.

A gate array is a semiconductor integrated-circuit device called a base chip produced by a semiconductor manufacturer by regularly arranging gates known as basic cells on a silicon chip. In order to implement logic and circuits designed by the user on the base chip, the manufacturer produces a photo mask or a plurality of photo masks for creating wires on the base chip. The semiconductor integrated-circuit device with wiring completed on the base chip is then delivered to the particular user.

In general, a gate array comprises basic cells, referred to hereafter simply as CMOS cells, which can each be configured as a CMOS circuit. However, even though a CMOS gate array offers advantages in that such a gate array consumes little power and allows tens of thousands of gates to be integrated, a CMOS circuit has a shortcoming of being highly sensitive to load capacitances. Therefore, in recent years, the gate array made of the so-called Bi-CMOS circuits employing bipolar circuits at the outputs of CMOS circuits has been getting highlighted.

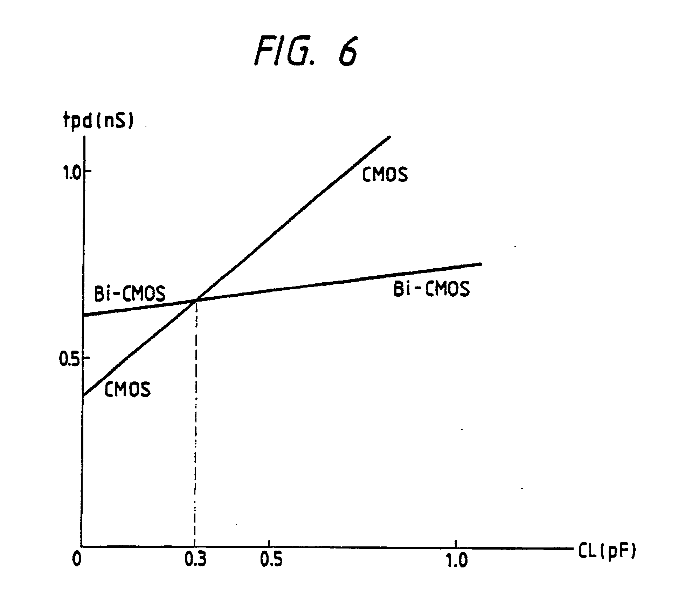

Fig. 6 shows a comparison of load capacitance dependence between a two-input NAND gate configured as a CMOS circuit and that configured as a Bi-CMOS circuit. The Bi-CMOS NAND gate has an advantage over the CMOS one in that the load capacitance dependence is 0.2 ns/pF for the Bi-CMOS circuit which is approximately five to six times smaller than 1.0 to 1.2 ns/pF for the CMOS circuit. For load capacitances smaller than 0.3 pF or so, however, it is obvious that the CMOS circuit is faster than the Bi-CMOS one. In addition, if a gate array is made of all Bi-CMOS basic cells, i.e. basic cells which are configured as Bi-CMOS circuits, it has been known that a problem arises due to the fact that the size of the Bi-CMOS chip is larger than a chip containing the same number of CMOS basic cells only. This is because each Bi-CMOS basic cell includes bipolar transistors at the output of the CMOS circuit.

According to an analysis conducted by the inventor of the invention, approximately 20 to 30% of all circuits employed in data processing systems comprising ordinary gate arrays are required to drive relatively large load capacitances at high speeds. That is to say, the inventor has learned that it is sufficient to build 20 to 30% of all the circuits by using the Bi-CMOS. In other words, even if all basic cells of a gate array are configured as Bi-CMOS circuits, approximately 70 to 80% of all the Bi-CMOS basic cells are used merely as CMOS circuits. In this case, much of the space occupied by bipolar transistors employed by the Bi-CMOS basic cells is wasted. In addition, due to the size limitation cited above, large-scale integration of all Bi-CMOS basic cells into a gate array chip can hardly be implemented. The inventor then devised a large-scale integration of a gate array by combining Bi-CMOS and CMOS cells at a ratio of the former to the latter of m/n, where m and n are both integers and m is smaller than n.

On the other hand, there is every indication that semiconductor integrated-circuit devices employing gate arrays are formed not manually but, instead, by resorting to a means such as Design Automation (DA) or Computer Aided Design (CAD). It is therefore desirable to design the base chip of a gate array that is easy to create using the DA or CAD. Now that a Bi-CMOS gate array comprises Bi-CMOS and CMOS cells at a mix ratio of m/n as is described above, the inventor has clarified that it is necessary to a certain extent to devise the layout of the Bi-CMOS and CMOS cells on the base chip so that the base chip can be designed by using the DA or CAD with ease. That is because the area of a Bi-CMOS basic cell is different from that of a CMOS basic cell. Note that regarding a Bi-CMOS gate array comprising Bi-CMOS and CMOS logical functional blocks, Japanese Patent Laid-open No. 63-140 with a disclosure date of January 5, 1989 already exists.

It is an object of the invention to provide a semiconductor integrated-circuit device such as a gate array comprising Bi-CMOS and CMOS cells at a combining ratio of m/n, where m and n are integers and m is smaller than n, with the layout of the Bi-CMOS and CMOS cells easily designable using the Design Automation (DA) or computer Aided Design (CAD).

The object described above and other objects as well as new features of the invention will become apparent from the description of the specification and its accompanying diagrams.

A representative of inventions disclosed in the specification is explained as follows.

In a semiconductor integrated-circuit device comprising Bi-CMOS and CMOS cells configurable in accordance with the invention into Bi-CMOS and CMOS circuits respectively with a combining ratio of the former to the latter of m/n, where m and n are both integers and m is smaller than n, the Bi-CMOS and CMOS cells are laid out in accordance with the invention so as to satisfy the relation $lx1/lx2 = l/l$ or $lx1/lx2 = l/k$, where $lx1$ and $lx2$ are the widths of the Bi-CMOS and CMOS cells respectively whereas l and k are both integers with l being greater than k. Note that with the Bi-CMOS and CMOS cells laid out in a matrix configuration, the width of a cell is defined to be the length of the cell as measured in the row direction.

It is more desirable to further arrange the cells in such a way that satisfies the relation $ly1/ly2 = l/l$ or $ly1/ly2 = g/h$, where lyl and ly2 are the heights of the Bi-CMOS and CMOS cells respectively whereas g and h are both integers with g being greater than h. Note that with the Bi-CMOS and CMOS cells laid out in a matrix configuration, the height of a cell is defined to be the length of the cell as measured in the column direction.

By arranging the cells into a layout described above, the cells are placed at locations abiding by a certain rule of regularity. Such a technique of cell arrangement allows not only the design of a semiconductor integrated-circuit device using the DA or CAD to be performed with ease, but also integration of cells or gates into the semiconductor integrated-circuit device to be implemented on a large-scale basis.

In the drawings

Fig. 1(a) is a block diagram of an embodiment implementing a gate array in accordance with the invention.

Fig. 1(b) is a diagram showing a layout of Bi-CMOS and CMOS cells which are enclosed by a dashed line 81 in Fig. 1(a).

Fig. 2(a) is a block diagram of another embodiment implementing a gate array in accordance with the invention.

Fig. 2(b) is a diagram showing a layout of Bi-CMOS and CMOS cells which are enclosed by a dashed line 82 in Fig. 2(a).

Fig. 3(a) is a block diagram of still another embodiment implementing a gate array in accordance with the invention.

Fig. 3(b) is a diagram showing a layout of CMOS and CMOS cells which are enclosed by a dashed line 83 in Fig. 3(a).

Fig. 4(a) is a diagram showing logic of a circuit example configured from a gate array provided by the invention.

Fig. 4(b) is a diagram showing an actual circuit of the logic shown in Fig. 4(a).

Fig. 4(c) is diagram showing a typical layout of Bi-CMOS and CMOS cells and typical wires connecting the cells for implementing the circuit shown in Fig. 4(a) as an embodiment in accordance with the invention.

Fig. 5 is a block diagram of yet another embodiment implementing a gate array in accordance with the invention.

Fig. 6 shows characteristic representing relations between load capacitances and propagation times of the Bi-CMOS and CMOS circuits for use in the explanation of the invention.

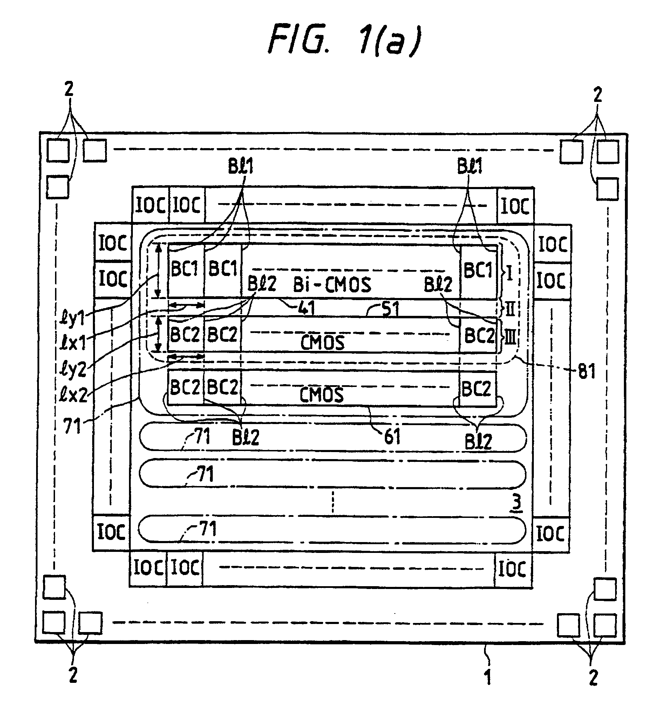

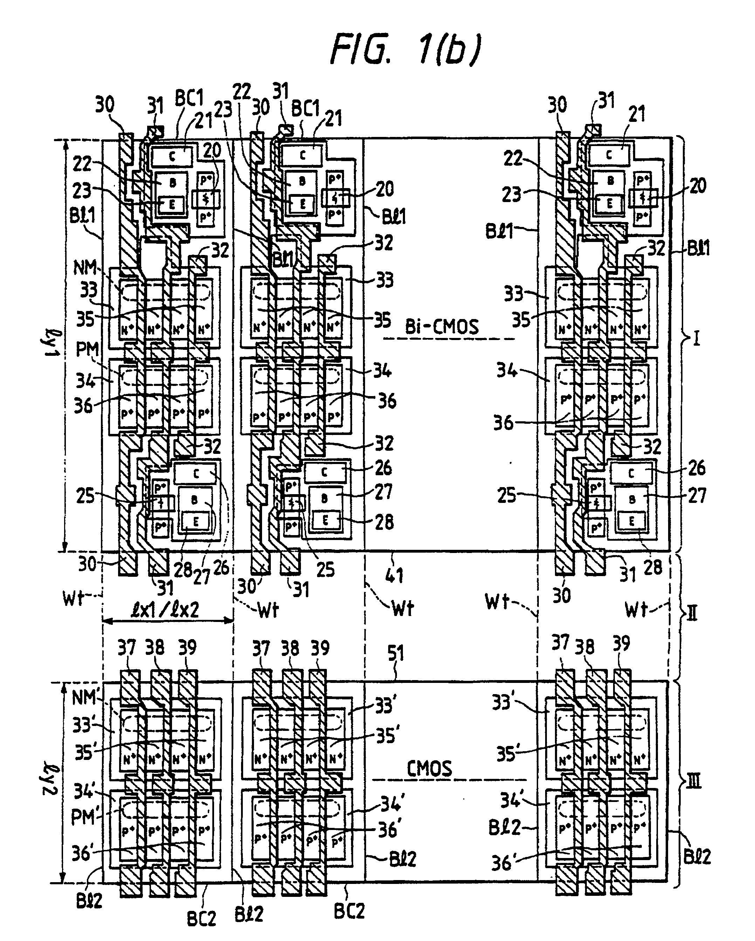

As shown in Fig. 1(a), a semiconductor integrated-circuit device adopting a master-slice technique is configured into a base chip 1 with a square plane section. An example of the base chip 1 is a crystal silicon board. On the perimeter along each side of the square semiconductor integrated-circuit, a plurality of input/output circuits IOC are provided and bonding pads (external pins) 2 are fixed.

The bonding pads (external pins) 2 are provided either for signals or power supplies. The base chip 1 may have bonding pads 2 with no special distinction between the signals and the power supplies or may have bonding pads 2 for the power supplies larger than those for the signals. The bonding pads 2 are made of a metal such as aluminum which is appropriate for bonding processes like thermal or ultrasonic-wave bonding. The bonding pads 2 are separated from each other by a proper gap so that when they are bonded, they are not shorted with each other even if they are somewhat shifted from their correct locations.

Each of the input/output circuits IOC is a unit circuit (cell) associated on a one-to-one basis with each of the external pins 2. The unit circuit (cell) includes elements which can be configured by the user into an input, output or input/output circuit in accordance with an application. An output circuit is typically configured from a Bi-CMOS circuit because an output circuit is, in general, required to drive a relatively a large capacitive load. None the less, the configuration of an output circuit is not limited to a Bi-CMOS circuit. The input portion of an input/output circuit IOC is configured from, for example, a CMOS or TTL input circuit depending upon the external device. In the case of a TTL input circuit, a level converting facility is provided for converting the input signal from the TTL level to the CMOS level. An for the input/output circuit of a Bi-CMOS gate array, there is used a technology disclosed in U.S. Patent No. 4,710,842 which were issued on December 1, 1987 and assigned to the same assignee and U.S. Serial No. 07/346,409 or 06/863,721. The output portion of the input/output circuit IOC can be configured from a TTL output circuit in addition to a Bi-CMOS circuit as is described above.

In the embodiments, Bi-CMOS and CMOS basic cells (BC1 and BC2 respectively) are provided for forming an internal logic circuit in order, among other things, to increase the speed and to enhance the integration scale of the internal logic circuit and to make the layout design of the base chip such as a gate array by means of the DA or CAD easy to implement.

Here, a basic cell is a smallest basic unit used in designing the layout of a basic chip and, in this specification, is defined as a configuration comprising either of the two types of cells : the CMOS cell (BC2) and the Bi-CMOS cell (BC1). The CMOS cell (BC2) is configured from a plurality of P-channel and M-channel MOSFETs whereas the Bi-CMOS cell (BC1) is configured from a plurality of P-channel and N-channel MOSFETs and one or two bipolar transistors. The Bi-CMOS cell (BC1) may include resistors as well.

A cell area 3 shown in Fig. 1(a) is typically configured as follows. An array 41 of Bi-CMOS cells (BC1) is placed on the first row. Arrays 51 and 61 of CMOS cells (BC2) are located on the second and third rows respectively. The cell area 3 shown in Fig. 1(a) is occupied by a plurality of cell matrices 71 each comprising the same set of cell arrays as the cell arrays 41, 51 and 61. Accordingly, the configuration of the internal logic circuit comprises the Bi-CMOS cells (BC1) and CMOS cells (BC2) with a basic-cell combining ratio of the former to the latter of 1/2. It should be noted, however, that the internal logic circuit is not restricted particularly to the above configuration. For example, an array 41 of Bi-CMOS cells (BC1) can be further added on a row separate from the cell matrix 71.

According to an analysis conducted by the inventor of the invention, in a data processing system comprising ordinary gate arrays, the circuits, which are designed to meet requirements for operating at high speeds and driving relatively large load capacitances, constitute 20 to 30% of the entire circuit population. Accordingly, by including as many Bi-CMOS cells BC1 as 30% or more in a gate array as described above, the gate array is applicable to the great majority of data processing systems. The reason why Bi-CMOS cells BC1 are provided in a quantity larger than required is that a Bi-CMOS cell BC1 can be diverted to function as a CMOS circuit as will be described later.

As such, since the number of Bi-CMOS cells BC1 overwhelmingly exceeds that of CMOS cells BC2 in a combined arrangement comprising two different types of basic cells, the average occupied area per cell inevitably increases. This is because the cell width or the cell length in the array direction lx1 of a Bi-CMOS cell BC1 is greater than the cell width lx2 of a CMOS cell BC2. In other words, the horizontal pitch of a Bi-CMOS cell BC1 is different from that of a CMOS cell BC2. Therefore, a boundary line Bl1 between any two Bi-CMOS cells BC1 on the cell array 41 is not aligned with a boundary line Bl2 between any two CMOS cells BC2 on the cell array 51. The misalignment of the border lines, in turn, increases the amount of data to be processed during the layout design using the DA or CAD. As a result, the time required to develop the layout of a gate array is unavoidably lengthened.

In order to solve the above problem, the width lx1 of a Bi-CMOS cell BC1 is made equal to the width lx2 of a CMOS cell BC2 (lx1 : lx2=1 :1). Conseqently, the cell heights ly1 and ly2 or the cell lengths in the vertical direction of the Bi-CMOS and CMOS cells BC1 and BC2 respectively can be freely set.

As a result, the border lines Bl1 of the Bi-CMOS cells BC1 can be aligned with the border lines Bl2 of the CMOS cells BC2. The alignment of the border lines Bl1 with the border lines Bl2, in turn, allows the layout design using the DA or CAD to be carried out with ease. That is to say, by imposing a certain kind of regularity upon the horizontal cell widths of the two different types of basic cells, arrangement of cells by using an automatic layout means and wiring design by using automatic wiring software are simplified. During the automatic layout design, the locations of circuits are arranged several times on a trial basis in an attempt to find out an optimum layout. It is therefore necessary to make the horizontal cell widths of the two different types of basic cells uniform as described above of automatic layout design is to be performed.

Fig. 1(b) is a diagram showing a typical actual layout of an area 81 enclosed by a dashed line in Fig. 1(a).

First of all, the following description begins with an explanation of the configuration of the two basic cells : the Bi-CMOS cell BC1 and the CMOS cell BC2.

A Bi-CMOS cell BC1 typically comprises three N-channel MOSFETs, three P-channel MOSFETs, two NPN bipolar transistors and two resistors. Note, however, that a Bi-CMOS cell BC1 is not particularly restricted to such a configuration. The three N-channel MOSFETs are formed on an area denoted by a dashed line NM whereas the three P-channel MOSFETs are formed on an area denoted by a dashed line PM. It is obvious from the figure that gate electrodes 30, 31 and 32 of the three N-channel MOSFETs which are made of polycrystalline silicon are formed as common bodies also functioning as counterpart gate electrodes of the three P-channel MOSFETs. The three N-channel MOSFETs include an N$^+$ region 35 which is used as a source or drain region created in a P-well region 33. The three P-channel MOSFETs include a P$^+$ region 36 which is used as a source or drain region created in an N-well region 34. One of the two NPN bipolar transistors includes an N$^+$ region 21 used as a collector drawn layer C, a P region 22 used as a base B and an N$^+$ region 23 used as an emitter E created in the P region 22. The other NPN bipolar transistor includes an N$^+$ region 26 used as a collector drawn layer C, a P region 27 used as a base B and an N$^+$ region 28 used as an emitter E created in the P region 27. One of the two resistors comprises a P$^+$ region 20 created beside one of the NPN bipolar transistors whereas the other resistor comprises a P$^+$ region 25 created beside the other NPN bipolar transistor. As shown in th figure, the two NPN bipolar transistors are laid out in the cell BC1 so as to sandwich some of the three N-channel MOSFETs and the three P-channel MOSFETs. As a result, the cell width lx1 or the length of the cell in the horizontal direction is reduced. On the other hand, the cell height ly1 or the length of the cell in the vertical direction is somewhat increased.

As for the CMOS cell BC2, regions for three P-channel MOSFETs and three N-channel MOSFETs are typically included. It should be noted, however, that a CMOS cell BC2 is not particularly restricted to such a configuration. The three N-channel MOSFETs are formed on an area denoted by a dashed line NM' whereas the three P-channel MOSFETs are formed on an area denoted by a dashed line PM'. It is obvious from the figure that gate electrodes 37, 38 and 39 of the three N-channel MOSFETs which are made of polycrystalline silicon are formed as common bodies also functioning as counterpart gate electrodes of the three P-channel MOSFETs. The three N-channel MOSFETs include an N$^+$ region 35' which is used as a source or drain region created in a P-well region 33'. The three P-channel MOSFETs include a P$^+$ region 36' which is used as a source or drain region created in an N-well region 34'. Since the cell width lx2 or the length of the cell in the horizontal direction of the CMOS basic cell BC2 is made the same as the width lx1 of the Bi-CMOS basic cell BC1, the cell height ly2 or the length of the cell in the vertical direction becomes somewhat smaller than the height ly1.

Here, the fact that the cell width lx1 of the Bi-CMOS basic cell BC1 is equal to the cell width lx2 of the CMOS basic cell BC2 is of particular interest (lx1: lx2=1 :1). That is to say, even though the cell array 41 comprises a plurality of said Bi-CMOS cells BC1 and the cell arrays 51 and 61 each comprise a plurality of said CMOS cells BC2, the cell layout pitch of the the Bi-CMOS cell BC1 on the cell array 41 is almost the same as the cell layout pitch of the CMOS cell BC2 on the cell arrays 51 and 61. In other words, the pitch of a wiring track Wt fixed along the boundary line BI1 between adjacent two of the Bi-CMOS cells BC1 on the cell array 41 can be used as the same pitch as a wiring track Wt fixed along the boundary line BI2 between adjacent two of the CMOS cells BC2 on the cell array 51 and 61.

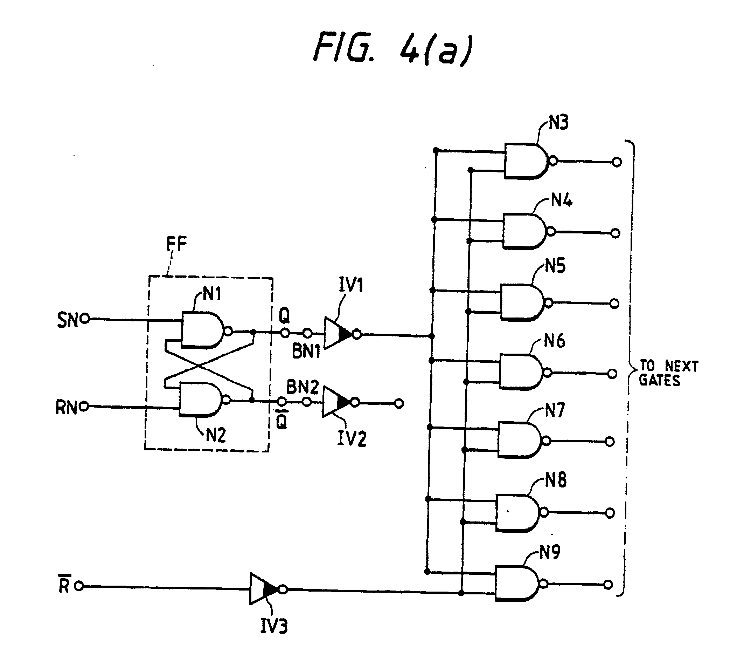

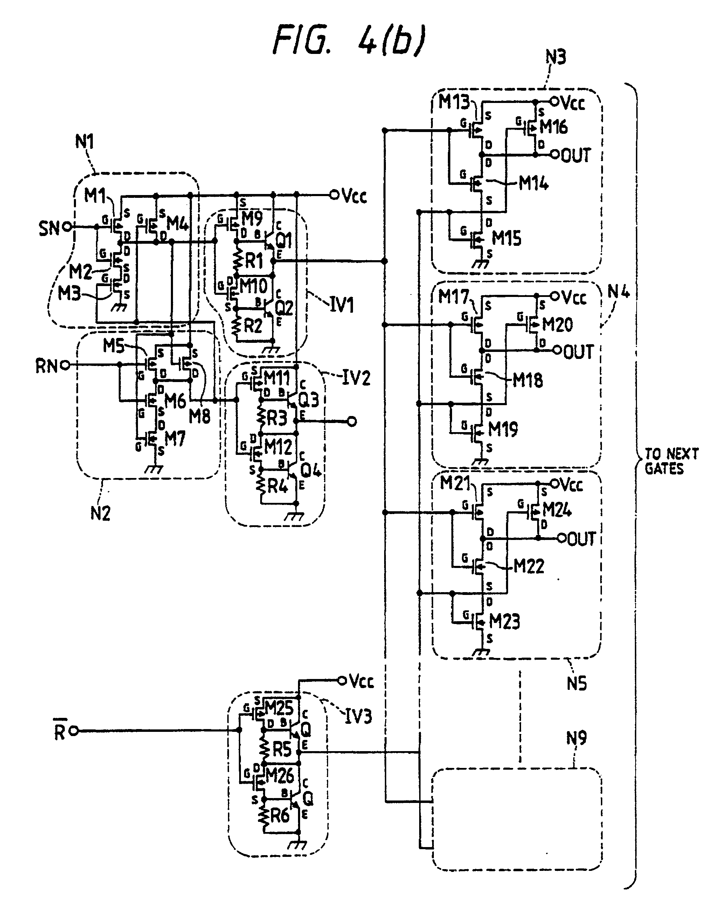

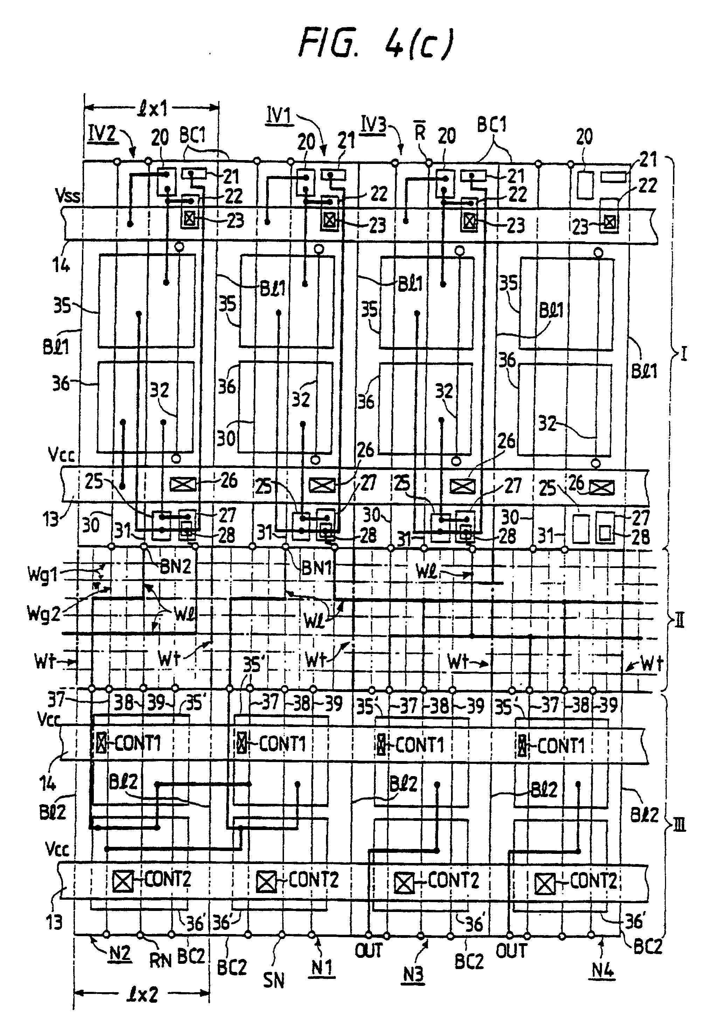

Fig. 4(a) is a diagram showing logic of a circuit example which can be configured from a gate array provided by the invention. As shown in the figure, a reset signal provided from a reset pin R̄ is used to distribute one of two outputs Q and Q̄ of a flip-flop FF to a plurality of NAND gates N3, N4, N5, N6, N7 and N9.

Besides the flip-flop FF and the NAND gates N3, N4, N5, N6, N7 and N9, the circuit shown in Fig. 4(a) includes inverters INV1, INV2 and INV3. The flip-flop FF has two inputs SN and RN and is configured from a CMOS circuit. The input pins BN1 and BN2 of the inverters INV1 and INV2 are respectively connected to the two output pins Q and Q̄ of the flip-flop FF. The reset signal is furnished to the inverter INV3. The outputs of the inverter INV1 and INV3 are distributed to pairs of input pins of the NAND gates N3, N4, N5, N6, N7 and N9.

Being connected to the multiple NAND gate circuits N3 to N9, the outputs of the inverters INV1 and INV3 drive large load capacitances. Accordingly, the inverters INV1 and INV3 are each configured from a Bi-CMOS-circuit which is less sensitive to a load capacitance. Like the inverter INV1, the inverter INV2 is also connected to gates not shown in the figure. Since the gates connected to the inverter INV2 have large capacitances, the inverter INV2 is also configured from a Bi-CMOS circuit.

Fig. 4(b) is an actual circuit implementing the logic shown in Fig. 4(a). The flip-flop FF is configured from two NAND gates N1 and N2. Each of the NAND gates N1 and N2 is formed from a CMOS basic cell comprising two P-channel MOSFETs M1 and M4 and two N-channel MOSFETs M2 and M3. The sources S of the P-channel MOSFETs M1 and M4 are connected to a power supply voltage Vcc and their drains D are connected to each other. The drains D of the P-channel MOSFETS M1 and M4 are further connected to the drain D of the N-channel MOSFET M2. The source S of the N-channel MOSFET M2 is connected to the drain D of the N-channel MOSFET M3 while the source S of the N-channel MOSFET M3 is wired to a ground potential point of the circuit.

In addition, the gates G of the P-channel MOSFET M1 and the N-channel MOSFET M2 are tied to each other and used as the input pin SN whereas the gates G of the P-channel MOSFET M4 and the N-channel MOSFET M3 are tied to each other and connected to the drain D of a P-channel MOSFET M8 which serves as an element in the NAND gate N2 to be described later. The drains D of the P-channel MOSFETs M1 and M4 which are tied together are used as an output line connected to the gates G of a P-channel MOSFET M9 and an N-channel MOSFET M10. As will be described later, the P-channel MOSFET M9 and the N-channel MOSFET M10 form the input portion of the inverter INV1.

When structuring a NOR gate circuit as a counterpart of the above NAND configuration, the P-channel MOSFETs M1 and M4 are put in a series connection while the N-channel MOSFETs M2 and M3 are wired to form a parallel circuit as opposed to the above NAND gate circuit.

The NAND gate N2 has a configuration identical with that of the NAND gate N1 described above. The NAND gate N2 is formed from a CMOS basic cell comprising two P-channel MOSFETs M5 and M8 and two N-channel MOSFETs M6 and M7. The sources S of the P-channel MOSFETs M5 and M8 are connected to a power supply voltage Vcc and their drains D are connected to each other. The drains D of the P-channel MOSFETS M5 and M8 are further connected to the drain D of the N-channel MOSFET M6. The source S of the N-channel MOSFET M6 is connected to the drain D of the N-channel MOSFET M7 while the source S of the N-channel MOSFET M7 is wired to a ground potential point of the circuit.

In addition, the gates G of the P-channel MOSFET M5 and the N-channel MOSFET M6 are tied to each other and used as the input pin RN whereas the gates G of the P-channel MOSFET M8 and the N-channel MOSFET M7 are tied to each other and connected to the drain D of a P-channel MOSFET M4 which serves as an element in the NAND gate N1 described previously. The drains D of the P-channel MOSFETs M5 and M8 and the N-channel MOSFET M6 which are tied together are used as an output line connected to the gates G of a P-channel MOSFET M11 and an N-channel MOSFET M12. As will be described later, the P-channel MOSFET M11 and the N-channel MOSFET M12 form the input portion of the inverter INV2.

When structuring a NOR gate circuit as a counterpart of the above NAND configuration, the P-channel MOSFETs M5 and M8 are put in a series connection while the N-channel MOSFETs M6 and M7 are wired to form a parallel circuit as opposed to the above NAND gate circuit.

In addition to the P-channel MOSFET M9 and the N-channel MOSFET M10 the inverter INV1 includes two resistors R1 and R2 and two bipolar transistors Q1 and Q2 which form the output portion of the inverter INV1. Similarly, in addition to the P-channel MOSFET M11 and the N-channel MOSFET M12, the inverter INV2 includes two resistors R3 and R4 and two bipolar transistors Q3 and Q4 which form the output portion of the inverter INV2.

The gates G of the P-channel MOSFET M9 and the N-channel MOSFET M10 employed in the inverter INV1 are both connected to the drain D of the P-channel MOSFET M4 described earlier. The source S of the P-channel MOSFET M9 and the collector C of the bipolar transistor Q1 are both connected to the power supply voltage Vcc. The drain D of the P-channel MOSFET M9 is connected to the base B of the bipolar transistor Q1. The emitter E of the bipolar transistor Q1 is connected to the collector C of the bipolar transistor Q2 and the drain D of the N-channel MOSFET M10. The base B of the bipolar transistor Q2 is connected to the source S of the N-channel MOSFET M10 and the emitter E of the bipolar transistor Q2 is connected to the ground potential point of the circuit. The resistor R1 is hooked up between the drains D of the P-channel MOSFET M9 and the N-channel MOSFET M10. The resistor R2 is hooked up between the source S of the N-channel MOSFET M10 and the emitter E of the bipolar transistor Q2.

The bipolar transistors Q1 and Q2 function as a totem pole push-pull circuit. The emitter E of the bipolar transistor Q1 and the collector C of the bipolar transistor Q2 which are tied to each other are used as the output line of the inverter INV1. The output line of the inverter INV1 is connected to the gates of P-channel MOSFETs M13, M17, M21 and so on and N-channel MOSFETs M14, M18, M22 and so on. The P-channel MOSFET M13 and the N-channel MOSFET M14 form the input portion of the NAND gate N3. Similarly the P-channel MOSFET M17 and the N-channel MOSFET M18 form the input portion of NAND gate N4 while the P-channel MOSFET M21 and the N-channel MOSFET M2 form the input portion of the NAND gate N5.

The inverter INV2 has a configuration identical with that of the inverter INV1.

The gates G of the P-channel MOSFET M11 and the N-channel MOSFET M12 employed in the inverter INV1 are both connected to the drain D of the P-channel MOSFET M8 described earlier. The source S of the P-channel MOSFET M11 and the collector C of the bipolar transistor Q3 are both connected to the power supply voltage Vcc. The drain D of the P-channel MOSFET M11 is connected to the base B of the bipolar transistor Q3. The emitter E of the bipolar transistor Q3 is connected to the collector C of the bipolar transistor Q4 and the drain D of the N-channel MOSFET M12. The base B of the bipolar transistor Q4 is connected to the source S of the N-channel MOSFET M12 and the emitter E of the bipolar transistor Q4 is connected to the ground potential point of the circuit. The resistor R3 is hooked up between the drains D of the P-channel MOSFET M11 and the N-channel MOSFET M12. The resistor R4 is hooked up between the source S of the N-channel MOSFET M12 and the emitter E of the bipolar transistor Q4.

The bipolar transistors Q3 and Q4 function as a totem pole push-pull circuit. The emitter E of the bipolar transistor Q3 and the collector C of the bipolar transistor Q4 which are tied to each other are used as the output line of the inverter INV2. The output line of the inverter INV2 is connected to gates with large load capacitances which are not shown in the figure.

The configuration of the inverter INV3 is also identical with those of the inverters INV1 and INV2 except that the gates of a P-channel MOSFET M25 and an N-channel MOSFET M26 which are tied to each other are connected to the reset pin R̄.

Bipolar transistors Q5 and Q6 function as a totem pole push-pull circuit. The emitter E of the bipolar transistor Q5 and the collector C of the bipolar transistor Q6 which are tied to each other are used as the output line of the inverter INV3. The output line of the inverter INV3 is connected to the gates of P-channel MOSFETs M16, M20, M24 and so on and N-channel MOSFETs M15, M19, M23 and so on.

The NAND gate N3 comprises two P-channel MOSFETs M13 and M14 and two N-channel MOSFETs M14 and M15.

The sources S of the P-channel MOSFETs M13 and M16 are connected to the power supply voltage Vcc and their drains D are connected to each other. The drains D of the P-channel MOSFETS M13 and M16 are further connected to the drain D of the N-channel MOSFET M14. The source S of the N-channel MOSFET M14 is connected to the drain D of the N-channel MOSFET M15 while the source S of the N-channel MOSFET M15 is wired to the ground potential point of the circuit.

In addition, the gates G of the P-channel MOSFET M13 and the N-channel MOSFET M14 are tied to each other and connected to the output line of the inverter INV1 as described earlier. Similarly, the gates G of the P-channel MOSFET M16 and the N-channel MOSFET M15 are tied to each other and connected to the output line of the inverter INV2 as described previously.

The drains D of the P-channel MOSFETs M13 and M16 which are tied to each other are used as the output line of the NAND gate N3.

The configurations of the NAND gates N4, N5, N6, N7, N8 and N9 are identical with that of the NAND gate N3.

Fig. 4(c) is a wiring diagram for the circuit shown in Fig. 4(b) when implemented using the gate array shown in Fig. 1(a).

The inverters INV1, INV2 and INV3 which utilize BI-CMOS circuits as shown in Fig. 4(b) are configured using Bi-CMOS cells BC1 as shown in Fig. 4(c). On the other hand, the NAND gates N3 to N9 which utilize CMOS circuits as shown in Fig. 4(b) are configured using CMOS cells BC2 as shown in Fig. 4(c).

By configuring a Bi-CMOS circuit using Bi-CMOS cells BC1 and a CMOS circuit using CMOS cells BC2 as such, the number of Bi-CMOS cells BC1 can be held down at a value of the order of 30% of the entire basic cell population. Accordingly, combining the two different types of basic cells allows integration to be carried out on a larger-scale basis than a gate array comprising only Bi-CMOS cells BC1.

As shown in Fig. 4(c), a plurality of Bi-CMOS cells BC1 are laid out on an area I. Each Bi-CMOS cell BC1 comprises an N+ diffusion layer 35 for sources and drains of N-channel MOSFETs, a P+ diffusion layer 36 for sources and drains of P-channel MOSFETs, polysilicon gates 31, 32 and 33 of the MOSFETs, collectors 21 and 26, bases 22 and 27 and emitters 23 and 28 of bipolar transistors and resistors 20 and 25.

The emitter 23 is tied to a power supply line 14 which has a ground potential Vss while the collector 26 is wired to a power supply line 13 which is supplied by the power supply voltage Vcc.

As shown in Fig. 4(c), a plurality of CMOS cells BC2 are laid out on an area III. Each CMOS cell BC2 comprises an N+ diffusion layer 35' for sources and drains of N-channel MOSFETs, a P+ diffusion layer 36' for sources and drains of P-channel MOSFETs and polycrystalline silicon gates 37, 3B and 39 of the MOSFETs.

CONT1 is connected to a portion of the N+ layer 35' and the power supply line 14 which has the ground potential Vss while CONT2 is connected to a portion of the P+ layer 36' and the power supply line 13 which is fed by the power supply voltage Vcc.

An area II is a wiring area for wires connecting cell terminals and wires connected to external pins. Dotted lines Wg1 and Wg2 on the wiring area II are virtual wiring grates for arranging wiring tracks at regular intervals in both the horizontal and vertical directions so that the wiring tracks form a grate. All wires WI defined by the DA are laid out on the wiring tracks.

Dotted thick lines Wt are wiring tracks laid out on vertical boundaries between two adjacent Bi-CMOS cells BT1 and between two adjacent CMOS cells BT2. Since the widths lx2 and lx2, or the cell lengths in the horizontal direction, of the Bi-CMOS and CMOS cells are equal to each other and the pitches of the cell widths are mutually aligned, processing tasks to be performed by the DA or CAD software can be simplified. As a result, the layout design of the gate array can be carried out with ease.

As shown in the figure, terminals of the basic cells BT1 and BT2 are all located on the wiring tracks.

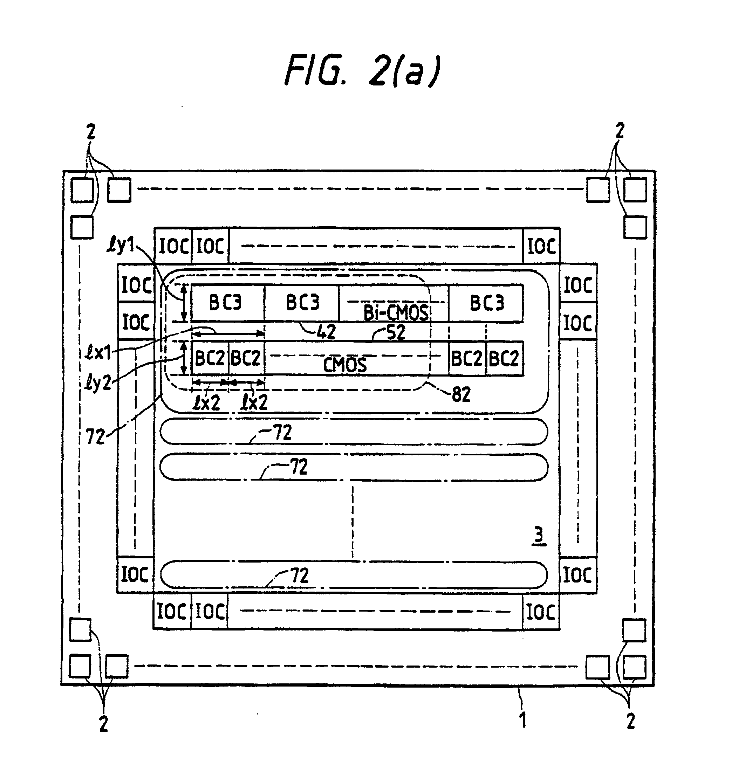

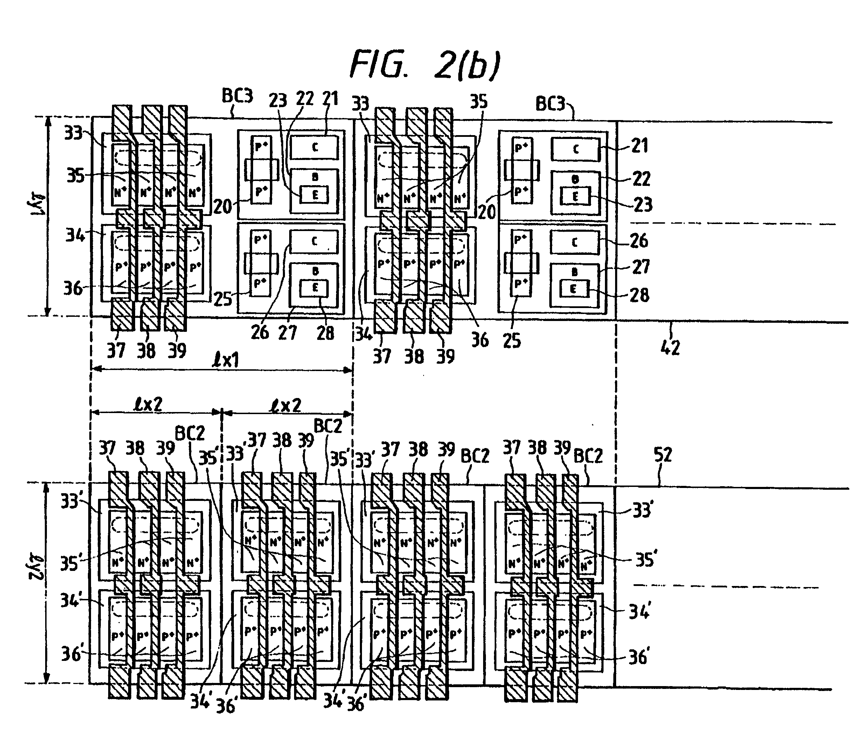

Fig. 2(a) is a block diagram of another embodiment implementing a gate array in accordance with the invention.

Much like the matrix of cells shown in Fig. 1(a), an array 42 of Bi-CMOS cells BC3 is laid out on the first row whereas an array 52 of CMOS cells BC2 is laid out on the second row. The cell arrays 42 and 52 laid on the first and second rows respectively form a pair of arrays 72. A plurality of such array pairs 72 are laid out on a cell region 3 as shown in Fig. 2(a). Since the width lx1 of a Bi-CMOS cell BC3 is twice the width lx2 of a CMOS cell BC2, in such a layout, the mix ratio of Bi-CMOS cells BC3 to CMOS cells BC2 is 1/2. It should be noted, however, that the embodiment is not particularly limited to such a configuration. For example, arrays of Bi-CMOS cells BC3 can be further added to such pairs of cell arrays 72.

In this embodiment, the height ly1 of the Bi-CMOS cell BC3 is made the same as the height ly2 of the CMOS cell BC2 (ly1 : ly2=1 : 1). A Bi-CMOS BC3 cell includes one bipolar transistor or a plurality of bipolar transistors and one resistor or a plurality of resistors. Moreover, spaces are required inside a Bi-CMOS cell BC3 for separating one element from another. Accordingly, the size of a Bi-CMOS cell BC3 is larger than that of a CMOS cell BC2. Since the heights ly1 and ly2 are made the same as described above, the ratio of the width lx1 to the width lx2 is in general l/k (lx1 : lx2=1 :k), where l and k are both integers with l being greater than k. In this particular embodiment, the ratio of lx1 to lx2 is 2/1 (lx1 : lx2=2 :1) as described previously.

By arranging basic cells in accordance with a certain rule of regularity as such, the layout design using the design tool such as the DA or the CAD can be performed with ease.

Since the bonding pads and the input/output circuits IOC have been explained, their detailed descriptions are omitted here.

Fig. 2(b) is a diagram showing a typical layout of the basic cells BC2 and BC3 enclosed by a dashed line 82 in Fig. 2(a).

The Bi-CMOS cell BC3 has almost the same configuration as that of the Bi-CMOS cell BC1 shown in Fig. 1(b). It is obvious from the figure, however, that two NPN bipolar transistors are located beside the N-channel and P-channel MOSFETs. Accordingly, the height ly1 of the Bi-CMOS cell BC3 can be made the same as the height ly2 of the CMOS cell BC2 while the ratio of the Bi-CMOS cell BC3's width lx1 to the CMOS cell BC2' width lx2 is made l/k (lx1 : lx2=1 : k), where l and k are both integers with l being greater than k.

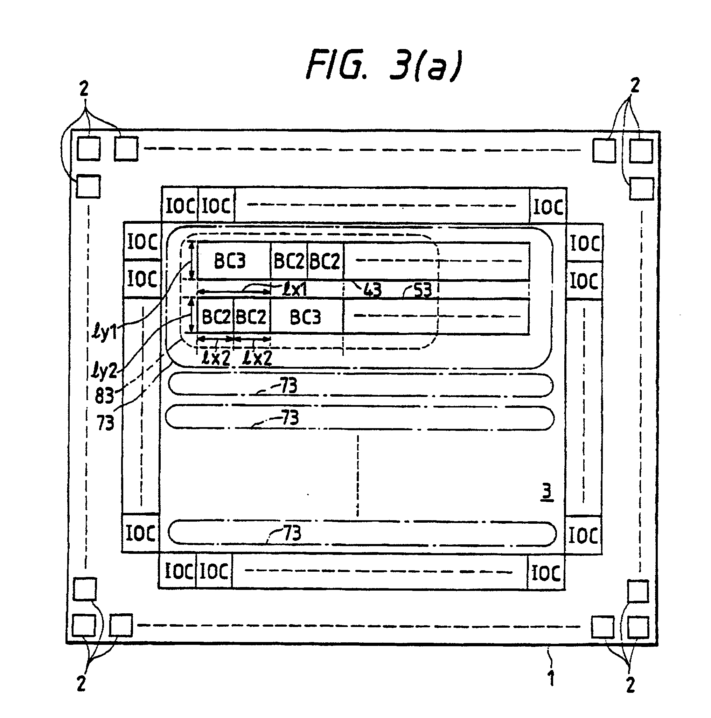

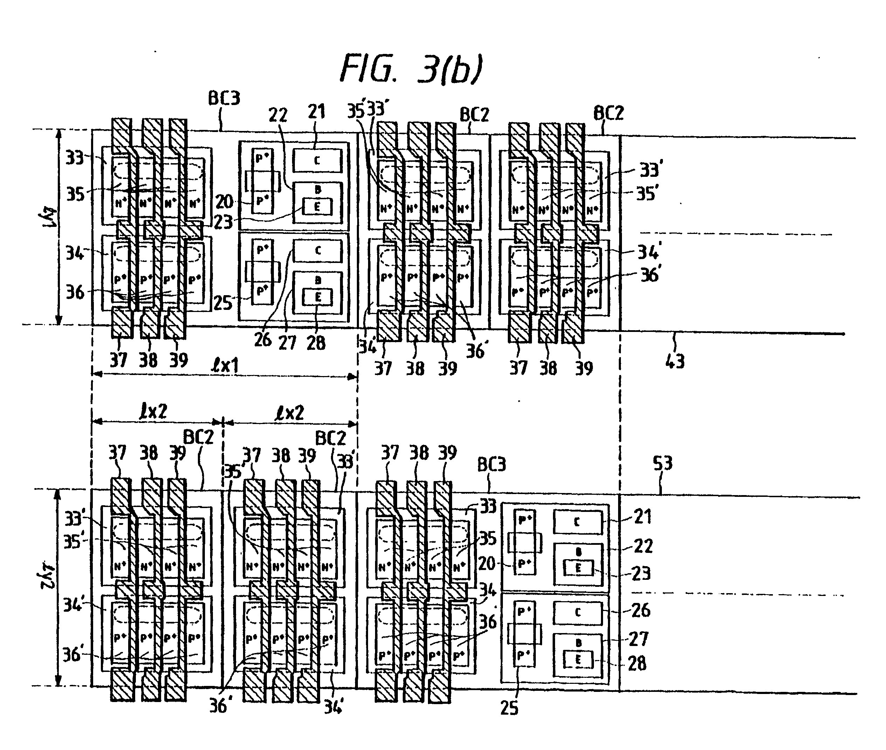

Fig. 3(a) is a block diagram of still another embodiment implementing a gate array in accordance with the invention.

The embodiment shown in Fig. 3(a) is a modified version of the embodiment shown in Fig. 2(a). In the embodiment shown in Fig. 3(a), Bi-CMOS cells BC3 and CMOS cells BC2 coexist in each single row such as the array 43 or 53. Here also, the height ly1 of the Bi-CMOS cell BC3 is made the same as the height ly2 of the CMOS cell BC2 (ly1 :ly2=1 :1) whereas the ratio of the Bi-CMOS cell BC3's lx1 to the CMOS cell BC1's lx2 is made l/k (lx1 :lx2=1 :k) where l and k are both integers with l being greater than k.

In this embodiment the basic cells are thus arranged in accordance with a certain rule of regularity. As a result, layout design using a tool such as the DA or CAD can be performed with ease.

Fig. 3(b) is a diagram showing a typical layout of Bi-CMOS and CMOS cells BC3 and BC2 which are enclosed by a dotted line 83 in Fig. 3(a).

The Bi-CMOS cell BC3 and the CMOS cell BC2 shown in Fig. 3(b) have the same configurations as the basic cells shown in Fig. 2(b).

Since the cell heights ly1 and ly2 and the cell widths lx1 and lx2 of the basic cells abide by a certain rule of regularity, the amount of work to be done by the design tool DA or CAD is reduced even if Bi-CMOS and CMOS cells are combined in each of the cell arrays.

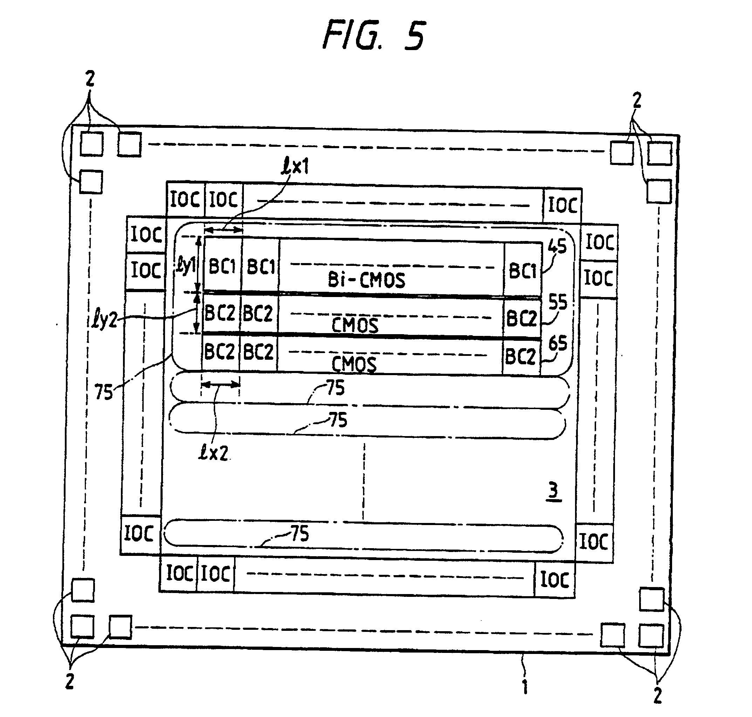

Fig. 5 is a block diagram of an embodiment implementing a Sea of Gates (SOG) in accordance with the invention.

Applying the invention to a Sea of Gates (SOG) further results in enhanced effects such as more efficient utilization and increased operational speeds of the basic cells.

Unlike the fixed channel gate array shown in Fig. 1(b), the Sea of Gates (SOG) requires no wiring region II. Since in cell areas of the Sea of Gates (SOG) basic cells are arranged without including a wiring region II, integration denser than the fixedchannel gate array is possible. In addition, since Bi-CMOS cells BC1 and CMOS cells BC2 are combined at an appropriate rate to form a cell region III, basic cells are utilized more efficiently. Furthermore, since the wiring region II does not exist in the Sea of Gates (SOG), the lengths of wires connecting basic cells can be made shorter. As a result, the Sea of Gates (SOG) has operational speeds higher than the fixed channel gate array.

Moreover, since the Bi-CMOS cells BC1 and CMOS cells BC2 are arranged in a layout abiding by the rule of regularity for the embodiment shown in Fig. 1(a), the Sea of Gates (SOG) can be designed with ease using the tool DA or CAD.

The inventions invented by the inventor have been explained in actual terms based on the embodiments. None the less the inventions are not limited to the cited embodiments only. Rather, it is needless to say that there are a variety of modified versions of embodiments which fall under a category not deviating from the gists of the inventions. For example, an internal circuit can be configured by appropriately mixing arrays containing either Bi-CMOS or CMOS basic cells only like the cell arrays of the embodiment shown in Fig. 1(a) or Fig. 2(a), with arrays which each include both the Bi-CMOS and CMOS basic cells like the cell arrays of the embodiment shown in Fig. 5.

Note that the embodiments shown in Fig. 2(a) and 3(a) can also be configured as a Sea of Gates (SOG) as well.

If a variety of wafers each having a different ratio of Bi-CMOS cells to CMOS cells and a different layout of the basic cells are prepared, the user can then select a wafer that matches the desired logic circuit.

The inventions can be widely applied to a semiconductor integrated-circuit device which implements a desired circuit through wiring design on basic cells embedded in a wafer such as a gate array.

An effect obtained from a representative of the inventions disclosed in the specification can be described as follows. The layout design of a semiconductor integrated-circuit device created by configuring two different kinds of basic cells using a master slice-technique can be performed with ease.

**Claims**

1. A semiconductor integrated-circuit device to be created using an automatic wiring system, said semiconductor integrated-circuit device comprising a plurality of basic cells arranged in a matrix form having a plurality of first basic cells with the length in the row direction of each of said first basic cells being lx1, the length in the column direction of each of said first basic cells being ly1, and a plurality of second basic cells with the length in the row direction of each of said second basic cells being lx2 and the length in the column direction of each of said second basic cells being ly2,

wherein the ratio of the length lx1 to the length lx2 is l/k, where l and k are both integers with l being equal to or greater than k and

wherein the ratio of the length ly1 to the length ly2 is g/h, where g and h are both integers with g being equal to or greater than h.

2. A semiconductor integrated-circuit device according to Claim 1, wherein each of said first basic cells comprises at least one bipolar transistor, a plurality of NMOSFETs and a plurality of PMOSFETs whereas each of said second basic cells comprises a plurality of NMOSFETs and a plurality of PMOSFETs.

3. A semiconductor integrated-circuit device according to Claim 2, wherein a plurality of first cell arrays each comprising said first basic cells arranged in the array direction are created, wherein a plurality of second cell arrays each comprising said second basic cells arranged in the array direction are created and wherein at least one of said second cell arrays are sandwiched between two of said first cell arrays.

4. A semiconductor integrated-circuit device according to Claim 2, wherein a plurality of third cell arrays each comprising a combination of said first basic cells and said second basic cells arranged in the array direction are created.

5. A semiconductor integrated-circuit device according to Claim 4, wherein the ratio of ly1 to ly2 is 1/1, where ly1 is the length in the column direction of each of said first basic cells and ly2 is the length in the column direction of each of said second basic cells.

6. A semiconductor integrated-circuit device according to Claim 5, wherein the ratio of lx1 to lx2 is 2/1, where lx1 is the length in the row direction of each of said first basic cells and lx2 is the length in the row direction of each of said second basic cells.

7. A semiconductor integtated-circuit device according to Claim 3, wherein the combining ratio of said first basic cells to said second basic cells is m/n, where m and n are both integers.

8. A semiconductor integrated-circuit device according to Claim 6, wherein the combining ratio of said first basic cells to said second basic cells is m/n, where m and n are both integers.

9. A semiconductor integrated-circuit device according to Claim 2, wherein each of said first basic cells includes resistors.

10. A semiconductor integrated-circuit device according to Claim 9, wherein each of said first basic cells includes two bipolar transistors.

11. A semiconductor integrated-circuit device according to Claim 10, wherein each pair of said bipolar transistors are arranged so as to sandwich said plurality of NMOSFETs and said plurality of PMOSFETs included the first basic cell containing said two bipolar transistors.

# FIG. 1(a)

# FIG. 1(b)

# FIG. 2(a)

FIG. 2(b)

# FIG. 3(a)

FIG. 3(b)

# FIG. 4(a)

# FIG. 4(b)

# FIG. 4(c)

# FIG. 5

FIG. 6

## European Patent Office

## EUROPEAN SEARCH REPORT

Application Number

EP 91 30 0424

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | EP-A-0 133 131 (FUJITSU LTD) * Claim 6; page 7, line 18 - page 9, line 7; figures 7A-9 * | 1-2,7-10 | H 01 L 27/118 |
| A | PROCEEDINGS OF THE IEEE 1989 CUSTOM INTEGRATED CIRCUITS CONFERENCE, San Diego, California, 15th - 18th May 1989, pages 8.5.1 - 8.5.4, IEEE, New York, US; H. HARA et al.: "A 350 ps 50K 0.8 mum BiCMOS gate array with shared bipolar cell structure" * Page 8.5.1, paragraph: "Circuit architecture"; figures 1A,1B * | 1,9 | |

TECHNICAL FIELDS SEARCHED (Int. Cl.5)

H 01 L

The present search report has been drawn up for all claims

| Place of search | Date of completion of the search | Examiner |
|---|---|---|
| THE HAGUE | 16-04-1991 | FRANSEN L.J.L. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document